Europäisches Patentamt

**European Patent Office**

Office européen des brevets

(11) Numéro de publication : **0 080 233**
**B1**

(12) **FASCICULE DE BREVET EUROPÉEN**

(45) Date de publication du fascicule du brevet :
28.08.85

(51) Int. Cl.⁴ : **H 05 K 9/00, G 06 K 19/06**

(21) Numéro de dépôt : **82201453.6**

(22) Date de dépôt : **17.11.82**

(54) **Procédé permettant de réaliser un circuit électronique protégé contre les charges électriques statiques.**

(30) Priorité : 20.11.81 FR 8121778

(43) Date de publication de la demande :
01.06.83 Bulletin 83/22

(45) Mention de la délivrance du brevet :
28.08.85 Bulletin 85/35

(84) Etats contractants désignés :
**CH DE FR GB IT LI SE**

(56) Documents cités :
**EP-A- 0 029 785**
**FR-A- 2 151 665**
**FR-A- 2 380 686**
**US-A- 3 969 815**

(73) Titulaire : **R.T.C. LA RADIOTECHNIQUE-COMPELEC**
**Société anonyme dite:**
**51 rue Carnot BP 301**
**F-92156 Suresnes Cédex (FR)**
**FR**
**N.V. Philips' Gloeilampenfabrieken**
**Groenewoudseweg 1**
**NL-5621 BA Eindhoven (NL)**
**CH DE GB IT LI SE**

(72) Inventeur : **Parmentier, Paul**
**S.P.I.D. 209 rue de l'Université**
**F-75007 Paris (FR)**

(74) Mandataire : **Pinchon, Pierre et al**
**Société Civile S.P.I.D. 209 rue de L'Université**
**F-75007 Paris (FR)**

## Description

L'invention concerne un procédé pour protéger au moyen d'un écran contre les charges électriques statiques un circuit électronique disposé dans un support en matériau électriquement isolant, le support étant muni, au moins localement, de surfaces électriquement conductrices, recouvrant le circuit électronique, surfaces entre lesquelles existe un trajet préférentiel pour un courant électrique qui supprime le risque d'une décharge électrique par le circuit électronique.

Dans un procédé connu (de la demande de brevet français N° 2 480 008), les métallisations des surfaces de matière synthétique métallisées sont interconnectées par une connexion électrique d'un genre non décrit en détail entre les métallisations.

L'invention vise à fournir un procédé du genre mentionné dans le préambule, qui se prête à une réalisation en grandes séries, ne requérant qu'un nombre assez réduit d'opérations de fabrication.

A cet effet, le procédé conforme à l'invention est remarquable en ce que, un trou traversant est formé dans le support et en ce que des feuilles en matériau thermoplastique, électriquement conductrices ou recouvertes d'une couche conductrice sont appliquées de chaque côté du support, feuilles entre lesquelles est placé un circuit électronique disposé dans une cavité du support, après quoi lesdites feuilles sont pressées l'une vers l'autre au moins à l'endroit du trou en même temps qu'est fourni un apport de chaleur à l'aide duquel le matériau thermoplastique est soumis à un fluage et poussé au moins partiellement dans le trou, après quoi le matériau thermoplastique est refroidi sous pression de façon à pouvoir maintenir ledit trajet préférentiel par du matériau thermoplastique solidifié dans le trou.

Un procédé conforme à l'invention, qui concerne la technologie de fabrication du support, est en outre remarquable en ce que le support est formé par empilement de plusieurs feuilles thermoplastiques dont au moins certaines sont munies d'un premier trou qui est ménagé à l'endroit de la cavité du support, trou dont les dimensions correspondent à celles de ladite cavité et qui sont toutes munies d'un second trou, qui est ménagé à l'endroit du trou traversant du support et dont les dimensions correspondent à celles du trou traversant, puis, après qu'un circuit électronique ait été disposé dans la cavité que constituent ensemble lesdits premiers trous, le support fait des feuilles empilées est recouvert des deux côtés, de feuilles thermoplastiques recouvertes d'une couche conductrice et ensuite toutes les feuilles sont transformées par pression et apport de chaleur en un laminé.

Un procédé conforme à l'invention, qui convient notamment à la fabrication de cartes d'identification présentant des plages de contact électriques accessibles à partir de l'extérieur est en outre remarquable en ce qu'au moins une des feuilles électriquement conductrices ou recouvertes d'une couche conductrice est munie d'orifices qui sont placés en regard des plages de contact électrique accessibles à partir de l'extérieur, et lesdites plages de contact sont recouvertes d'un masque, puis l'apport de chaleur est fourni au matériau thermoplastique, et ensuite le masque est enlevé après la solidification du matériau thermoplastique.

La description ci-après, en se référant aux dessins annexés, le tout donné à titre d'exemple non limitatif, fera bien comprendre comment l'invention peut être réalisée.

La figure 1 représente, en coupe, une portion d'une carte d'identification de l'art antérieur.

La figure 2 représente, en coupe, la même portion d'une carte selon l'invention, avant fluage.

La figure 3 représente, en coupe, toujours la même portion d'une carte selon l'invention, terminée.

La figure 4 représente une carte d'identification en perspective.

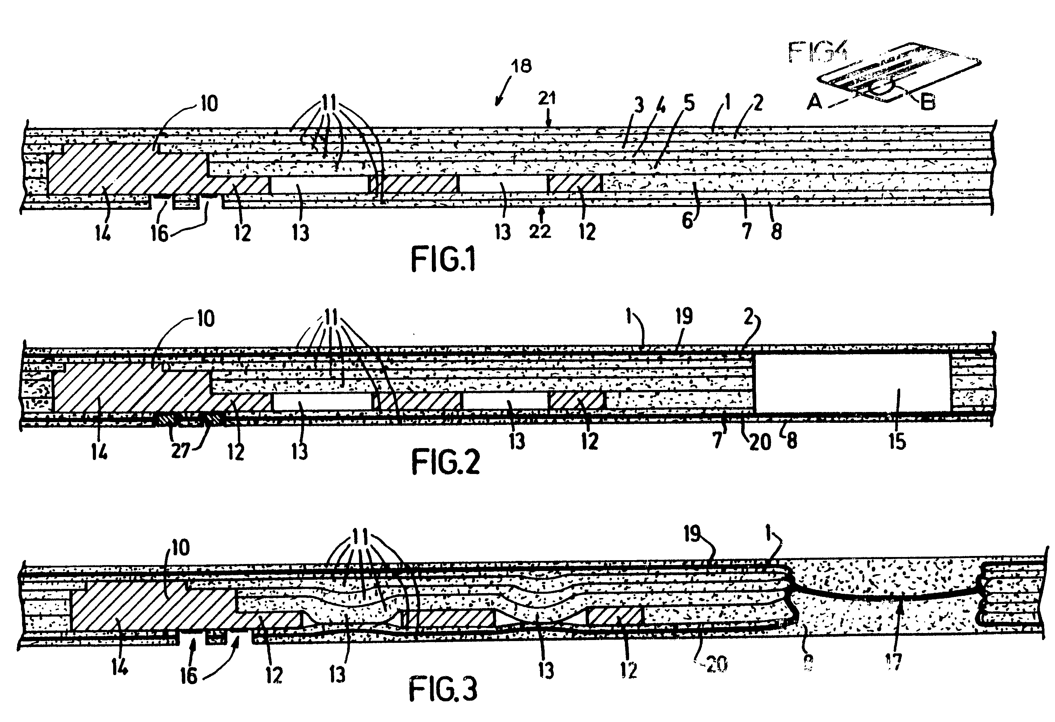

Sur la figure 4 est indiqué un cercle B qui délimite une portion de carte. Cette portion est représentée, en coupe selon la ligne A, par la figure 1.

Sur la figure 1 est représentée la partie contenant un circuit intégré, dans une forme de réalisation courante d'une carte d'identification.

Le circuit électronique comporte une pastille de circuit intégré montée dans un petit circuit imprimé 14 de faible épaisseur. La pastille est enrobée à l'intérieur de ce circuit au niveau de la surépaisseur 10.

Ce circuit 14 est inclus dans un empilage de feuilles 11 en chlorure de polyvinyle, dit PVC, ces feuilles étant pressées à chaud pour se souder entre elles en un bloc feuilleté qui forme un support 18 de faible épaisseur constitué principalement de matière isolante, à savoir la matière isolante du circuit imprimé 14 et la matière isolante des feuilles de PVC 11. Des orifices 16 percés dans les feuilles de surface 7 et 8 permettent d'accéder à des plages de contact portées par le circuit 14. Une prolongation amincie 12 du circuit 14, prolongation percée de trous 13, permet un ancrage du circuit imprimé dans le PVC des feuilles adjacentes, qui pénètrent dans les trous 13, comme l'indique la figure 3, lors du pressage à chaud qui soude entre elles les feuilles. En utilisant un tel empilage de feuilles on a la possibilité d'y ménager des cavités de forme assez compliquée si on le désire, en prévoyant des premiers trous de forme différente dans chaque feuille, ce qui permet d'adapter avec précision le bloc de PVC à la forme du circuit 14.

Le support 18 de la figure 1 ne comporte pas d'écran électrostatique. Pour l'en munir, on place au moins localement des surfaces électriquement conductrices sur les faces dudit corps. On peut par exemple rajouter des feuilles conductrices sur les faces supérieure 21 et inférieure 22 de ce corps. Mais, au lieu d'ajouter ultérieurement de telles feuilles à un corps 18 déjà élaboré, on peut remplacer, lors de la fabrication de ce corps, des feuilles de surface telles que par exemple les feuilles 1 et 8 ou les feuilles 2 et 7, par des feuilles conductrices. On peut aussi insérer, par exemple entre les feuilles 1 et 2 d'une part et les feuilles 7 et 8 d'autre part, une feuille conductrice mince.

Par le mot « support », on entend la partie de la carte constituée ici par les feuilles 2 à 7 situées entre les feuilles conductrices formant l'écran.

Pour réunir électriquement entre elles les feuilles conductrices situées chacune sur une face du corps, on réalise d'abord au moins un trou dans ledit corps. Ce trou, d'environ 2 millimètres de large, est représenté en 15 sur la figure 2. Pour la commodité du dessin il est situé à côté du circuit imprimé 14, mais il est bien évident qu'il peut être placé à n'importe quel endroit de la carte. Avantageusement même, il est placé assez loin du circuit imprimé et surtout assez loin d'éventuelles pistes magnétiques, placés à la surface de la carte afin que des déformations engendrées par la présence de ce trou, lors du pressage à chaud, se transmettent le moins possible à ces éléments.

On fournit ensuite les surfaces conductrices sous la forme d'une première feuille 19 de matériau thermoplastique, conducteur ou recouvert d'une couche conductrice, appliqué sur une face dudit corps, et d'une deuxième feuille 20 de ce même matériau, appliqué sur l'autre face du corps. La Demanderesse a utilisé avec succès des feuilles de PVC d'une épaisseur de 35 micromètres métallisées avec de l'aluminium, et insérées entre les couches 1 et 2 d'une part, et entre les couches 7 et 8 d'autre part. On pourrait aussi utiliser des feuilles en matériau thermoplastique rendues conductrices grâce à une charge de particules conductrices. Dans l'exemple montré ici, qui ne présente qu'une possibilité parmi beaucoup d'autres, les feuilles de PVC numérotées 1 à 8 ont respectivement les épaisseurs suivantes, en micromètres :

| feuille 1 | |
| feuille 2 | 120 (ensemble) |
| feuille 3 | |
| feuille 4 | |
| feuille 5 | 580 (ensemble) |
| feuille 6 | |
| feuille 7 | |
| feuille 8 | 150 (ensemble) |

Ceci forme donc avec les deux feuilles de 35 micromètres un empilage d'une épaisseur de 920 micromètres, qui est ramené par pressage à chaud, à 760 micromètres, en constituant un laminé.

Ce même pressage presse l'une vers l'autre les feuilles 19 et 20, en provoquant un fluage du matériau thermoplastique qui est poussé dans le trou 15. Le PVC étant un matériau thermoplastique, c'est en pratique les feuilles 1 et 19 ensemble, de même que les feuilles 20 et 8 ensemble, dont une certaine quantité de matière « coule » horizontalement lors du fluage, qui viennent remplir le trou 15. La figure 3 montre comment ces feuilles sont repoussées vers le centre du support, et comment des parties de surfaces conductrices des feuilles 19 et 20 sont amenées à se toucher le long d'une surface 17. Des conditions de pressage à chaud utilisées avec succès sont les suivantes : des plaques de feuilles de PVC empilées et comportant une pluralité de supports côte à côte de façon à engendrer une pluralité de cartes en une seule fois, sont placées entre les plaques chauffantes d'une presse. On applique une pression de 10 bars pendant 25 secondes sans chauffage, puis un chauffage à 160° pendant 7 minutes sous une pression de 140 bars, et on laisse refroidir pendant 6 minutes sous une pression de 170 bars. L'essentiel de ce processus consiste donc à appliquer, simultanément pendant au moins un certain temps, une pression et une élévation de température. Ces conditions de pression et de température sont d'ailleurs les mêmes que dans le cas d'une carte en PVC non munie d'un écran, et sont donc bien connues de l'homme de métier. L'effet obtenu dans le cas de l'invention est assez surprenant, car on pourrait s'attendre à ce que toutes les feuilles participent au remplissage du trou 15 en ne créant pas de connexion électrique entre les feuilles 19 et 20.

L'effet obtenu représenté sur la figure 3 peut s'expliquer par le fait que, lors de l'application du chauffage, les feuilles superficielles sont les premières chauffées et commencent à fluer avant que les feuilles internes aient commencé à ramollir suffisamment pour fluer elles aussi. Si d'ailleurs celles-ci arrivaient à introduire un peu de leur matière en 17 entre les surfaces conductrices, cela n'aurait pas d'inconvénient grave, car il n'est pas besoin d'avoir une conduction ohmique franche au niveau du contact 17, l'essentiel étant que le chemin de fuite offert à une charge électrostatique y soit plus court qu'au niveau du circuit électronique 14 à protéger. Le deuxième trou 15 est avantageusement réalisé lors de l'opération par laquelle on ménage les premiers trous pour le circuit imprimé 14, et le pressage à chaud est celui par lequel on termine la fabrication des cartes selon l'art antérieur : le procédé de l'invention n'introduit donc aucune opération de fabrication supplémentaire et la carte obtenue est ainsi très bon marché.

Il pourrait arriver, à cause de l'inhomogénéité due à l'absence de matériau thermoplastique sur les plages de contact portées par le circuit électronique que la carte terminée soit légèrement cintrée.

Pour éviter cela, avant de provoquer le fluage, on recouvre localement lesdites plages avec un masque 27 fait d'une matière différente de celle de la feuille thermoplastique 7, 8 et après avoir provoqué le fluage, on enlève le masque 27 qui recouvre les plages.

La matière du masque doit être différente de celle constituant les feuilles, afin qu'on puisse l'enlever sélectivement. Elle peut être avantageusement une encre pelable appliquée par sérigraphie sur le circuit imprimé 14. L'épaisseur de l'écran de sérigraphie est choisie de façon que l'épaisseur du masque soit telle qu'il affleure au niveau de la face extérieure de la carte, après le pressage à chaud. La Demanderesse utilise avec succès l'encre référencée SD 2951 de la firme Werner Peters KG, représentée en France par la Société SUPRATEX. L'adjectif « pelable » signifie que ce matériau, bien qu'assez résistant pour protéger les contacts lors des manipulations de fabrication, est rendu non adhérent par le choc thermique dû au pressage à chaud, et peut être enlevé très facilement ensuite par pelage. Selon l'invention, il a comme application nouvelle de servir de cale d'épaisseur et d'empêcher le déplacement latéral des couches 7, 8 lors du pressage et du fluage.

Une carte d'identification selon l'invention comporte donc un support 18 de faible épaisseur, constitué, dans l'exemple donné ici, par les feuilles 2 à 7 dans un premier trou desquelles est disposé le circuit imprimé 14, principalement en matière isolante, et dans lequel est inclus un circuit intégré, sur les deux faces 21, 22 duquel sont placées des feuilles 19, 20 conductrices ou recouvertes d'une couche conductrice, ces feuilles 19, 20 étant en matériau thermoplastique, le corps étant muni d'un second trou 15 et les feuilles présentant une déformation formant une surépaisseur s'étendant vers l'intérieur dans ledit trou et amenant certaines parties de surfaces conductrices des feuilles 19, 20 situées chacune sur une face opposée, en contact l'une avec l'autre le long d'une surface 17.

Lorsque les feuilles 19, 20 sont en matériau thermoplastique métallisé, par exemple en PVC aluminisé, l'aluminium n'a aucune adhérence avec le PVC de la feuille voisine. Une solution, excellente au demeurant, consiste à l'enduire de colle. Toutefois, ceci représente une complication dans la fabrication. Il est donc préférable de réaliser la métallisation au travers d'un pochoir, afin que la métallisation soit ajourée sur la majeure partie de la surface de la feuille. Ainsi, on laisse apparaître le PVC en de nombreux points de la surface, ce qui permet la soudure de la feuille avec la feuille voisine lors du pressage à chaud. On peut aussi perforer avec un emporte-pièce les feuilles 19, 20 de façon que les feuilles 1 et 2 d'une part, 7 et 8 d'autre part se soudent entre elles au travers des ajours des feuilles 19, 20.

### Revendications

1. Procédé pour protéger au moyen d'un écran contre les charges électriques statiques un circuit électronique disposé dans un support (18) en matériau électriquement isolant, le support étant muni, au moins localement, de surfaces électriquement conductrices, recouvrant le circuit électronique, surfaces entre lesquelles existe un trajet préférentiel pour un courant électrique qui supprime le risque d'une décharge électrique par le circuit électronique, caractérisé en ce qu'un trou traversant (15) est formé dans le support (18) et en ce que des feuilles (19, 20) en matériau thermoplastique, électriquement conductrices ou recouvertes d'une couche conductrice, sont appliquées de chaque côté du support, feuilles entre lesquelles est placé un circuit électronique disposé dans une cavité du support, après quoi lesdites feuilles sont pressées l'une vers l'autre au moins à l'endroit du trou (15) en même temps qu'est fourni un apport de chaleur à l'aide duquel le matériau thermoplastique est soumis à un fluage et poussé au moins partiellement dans le trou, après quoi le matériau thermoplastique est refroidi sous pression de façon à pouvoir maintenir ledit trajet préférentiel par du matériau thermoplastique solidifié dans le trou.

2. Procédé selon la revendication 1, caractérisé en ce que le support (18) est formé par empilement de plusieurs feuilles thermoplastiques (2, 3, 4, 5, 6, 7) dont au moins certaines sont munies d'un premier trou (13) qui est ménagé à l'endroit de la cavité du support, trou dont les dimensions correspondent à celles de ladite cavité, et qui sont toutes munies d'un second trou qui est ménagé à l'endroit du trou traversant (15) du support et dont les dimensions correspondent à celles du trou traversant, puis, après qu'un circuit électronique ait été disposé dans la cavité que constituent ensemble lesdits premiers trous, le support fait de feuilles empilées est recouvert des deux côtés de feuilles thermoplastiques (19, 20) recouvertes d'une couche conductrice et ensuite toutes les feuilles sont transformées par pression et apport de chaleur en un laminé.

3. Procédé selon l'une des revendications 1 ou 2, le support présentant des plages de contact électrique, caractérisé en ce que avant que lesdites feuilles électriquement conductrices ou recouvertes d'une couche conductrice soient pressées l'une vers l'autre, des orifices (16) sont réalisés dans au moins une desdites feuilles, lesdits orifices étant placés en regard des plages de contact électrique du circuit électronique ; lesdites plages de contact sont recouvertes d'un masque (27) puis l'apport de chaleur et de pression est fourni au matériau thermoplastique, et ensuite le masque (27) est enlevé après la solidification du matériau thermoplastique afin de rendre lesdites plages de contact accessibles à partir de l'extérieur.

### Claims

1. A method of protecting an electronic circuit (14) from electric static charges by means of a screen, said circuit being disposed in a support (18) of an electrically insulating material which is provided at least locally with electrically conducting surfaces which cover the electronic circuit (14) and between which a preferential path exists for an electrical current, which suppresses the risk of an electrical discharge through the electronic circuit (14) characterized in that a through-hole (15) is formed in the support (18) and in that foils (19, 20) of a thermoplastic material which are electrically conducting or are covered by a conductive layer, are provided on each side of the support (18), while between these foils (19, 20) is arranged an electronic circuit (14) disposed in a cavity of the support (18), after which the said foils (19, 20) are pressed towards each other at least at the area of the hole (15) and at the same time a quantity of heat is supplied by means of which the thermoplastic material is caused to flow and is pressed at least in part into the hole (15), whereupon the thermoplastic material is cooled under pressure so that the said preferential path through solidified thermoplastic material in the hole (15) can be maintained.

2. A method as claimed in Claim 1, characterized in that the support (18) is formed by a stack of several thermoplastic foils (2, 3, 4, 5, 6, 7), at least some of which are provided with a first hole (13), which is provided at the area of the cavity of the support (18) and whose dimensions correspond of those of the said cavity, while all these foils are provided with a second hole which is provided at the area of the through-hole (15) of the support and whose dimensions correspond to those of the through-hole, whereupon, after an electronic circuit (14) has been disposed in the cavity constituted by all the said first holes, the support composed of the stack of foils is covered on both sides by thermoplastic foils (19, 20) covered by a conductive layer, after which all foils are transformed by pressure and by supply of heat into a laminated structure.

3. A method as claimed in any one of Claims 1 or 2, in which the support has electrical contact regions, characterized in that, before the said foils which are electrically conducting or are covered by a conductive layer are pressed towards each other, orifices (16) are formed in at least one of the said foils, the said orifices being arranged opposite the electrical contact regions of the electronic circuit; and in that the said contact regions are covered by a mask (27) after which the quantity of heat and pressure are supplied to the thermoplastic material and the mask (27) is then removed after solidification of the thermoplastic material in order that the said contact regions are rendered accessible from the outside.

**Patentansprüche**

1. Verfahren zum Schützen einer auf einem Träger (18) aus elektrisch isolierendem Material angeordneten elektronischen Schaltung gegen elektrostatische Ladungen mit Hilfe eines Schirmes, wobei der Träger zumindest stellenweise die elektronische Schaltung bedeckende elektrisch leitende Oberfläche aufweist, zwischen denen eine bevorzugter Strompfad existiert, der die Gefahr eines elektrischen Überschlages in der elektronischen Schaltung beseitigt, dadurch gekennzeichnet, dass im Träger (18) ein durchgehendes Loch gebildet ist und dass Folien (19, 20) aus thermoplastischem, elektrisch leitendem oder leitend beschichtetem Material an jeder Seite des Trägers angebracht werden, wobei zwischen den Folien eine in einem Hohlraum des Trägers angeordnete elektronische Schaltung angebracht wird, wonach die Folien unter gleichzeitiger Zufuhr von Wärme zumindest an der Stelle des Loches (15) zusammengepresst werden, wobei das thermoplastische Material flüssig und zumindest teilweise in das Loch gedrückt wird, wonach das thermoplastische Material unter Druck abgekühlt und der Strompfad durch das im Loch verfestigte thermoplastische Material erhalten wird.

2. Verfahren nach Anspruch 1, dadurch gekennzeichnet, dass der Träger (18) durch Stapelung mehreren thermoplastischer Folien (3, 4, 5, 6, 7, 8) gebildet wird, von denen wenigstens einige mit einem ersten Loch (13) versehen sind, das an der Stelle des Hohlraumes des Trägers angebracht ist und dessen Abmessungen mit denen des Hohlraums übereinstimmen, und die alle mit einem zweiten Loch an der Stelle des durchgehenden Loches (15) mit den gleichen Abmessungen wie dieses Loch versehen sind, wobei, der aus den gestapelten Folien aufgebaute Träger anschliessend, nach dem Anbringen einer elektronischen Schaltung in dem aus der Gesamtzahl der ersten Löcher gebildeten Hohlraum, an beiden Seiten mit thermoplastischen mit einer Leitschicht bedeckten Folien (19, 20) bedeckt wird, und wobei anschliessend alle Folien unter Anwendung von Druck und Wärme laminiert werden.

3. Verfahren nach einem der Ansprüche 1 oder 2, unter Anwendung eines Trägers mit elektrischen Kontaktflächen, dadurch gekennzeichnet, dass in zumindest einer der Folien vor dem Aufeinanderpressen der elektrisch leitenden oder leitend beschichteten Folien Ausnehmungen (16) angebracht werden, wobei die Ausnehmungen mit den elektrischen Kontaktflächen der elektronischen Schaltung übereinstimmen, wobei die Kontaktflächen mit einer Maske (27) bedeckt werden, und wobei dem thermoplastischen Material anschliessend die Wärme zugeführt und der Druck auf das Material ausgeübt wird, wonach die Maske (27) nach der Verfestigung des thermoplastischen Materials von aussen her entfernt wird, um die Kontaktflächen zugänglich zu machen.

FIG.1

FIG.2

FIG.3

FIG.4